# EUROPEAN PATENT APPLICATION

(11) **EP 2 031 858 A2**
(43) Date of publication of application: **04.03.2009**
(21) Application number: 08252821.7
(22) Date of filing: 26.08.2008
(51) Int. Cl.: H04N 3/15

(54) **Imaging apparatus and method for driving solid-state imaging device**

(30) Priority: 27.08.2007 JP 2007219892
(71) Applicant: Fujifilm Corporation, Minato-ku Tokyo (JP)
(72) Inventor: Kobayashi, Hirokazu, Saitama (JP); Nishida, Yoshiyasu, Miyagi (JP)
(74) Representative: Stevens, Jason Paul

(57) **Abstract**

A solid-state imaging device 5 includes photoelectric conversion elements 51R, 51G, 51B; and photoelectric conversion elements 51r, 51g, 51b. An exposure period for the photoelectric conversion elements 51 r, 51 g, 51b is controlled shorter than that for the photoelectric conversion elements 51R, 51G, 51B. During the exposure period for the photoelectric conversion elements 51R, 51G, 51B, an imaging device driving section 10 applies a readout pulse to transfer electrodes V2, V6, reads out electric charges accumulated in the photoelectric conversion elements 51r, 51g, 51b into vertical electric charge transfer paths 54, and controls to start exposure of the photoelectric conversion element 51r, 51g, 51b. During a period from start of the exposure of the photoelectric conversion elements 51 R, 51G, 51 B to the applying of the readout pulse, the imaging device driving section 10 applies a transfer pulse of a low level to the transfer electrodes V1 to V8.

## Description

### BACKGROUND OF THE INVENTION

### 1. Technical Field

The invention relates to a solid-state imaging device and an imaging apparatus having a driving unit that drives the solid-state imaging device.

### 2. Description of the Related Art

In order to extend the dynamic range by obtaining low-sensitivity image data and high-sensitivity image data in a single photographing and combining them, there has been proposed a solid-state imaging device that includes photoelectric conversion elements having high sensitivity and photoelectric conversion elements having low sensitivity. In order to differentiate sensitivities among the photoelectric conversion elements, various methods are provided. For example, JP 2001-275044 A (corresponding to U.S. Patent No.7,030,923) describes a method of differentiating sensitivities among the photoelectric conversion elements by differentiating exposure times of the photoelectric conversion elements.

In order to differentiate the exposure time among the photoelectric conversion elements, JP 2001-275044 A applies a readout pulse to photoelectric conversion elements other than a part of the photoelectric conversion elements during an exposure period for the part of the photoelectric conversion elements, to read out electric charges accumulated in the photoelectric conversion elements, thereby controlling the exposure time of the photoelectric conversion elements except for the part of the photoelectric conversion elements. Generally, dangling bond exists on an interface between a silicon substrate and a gate insulating film above the silicon substrate, and this dangling bond serves as a center of generation-recombination and generates electrons. When the thus generated electrons enter the photoelectric conversion elements, white defects would be caused. In order to reduce the generation of the white defects, surfaces of the photoelectric conversion elements are often covered with a p-type impurity layer of high density at present. With this configuration, the hole density in the neighborhood of the interface increases and it becomes possible to cause the electrons, which are generated on the interface, to quickly recombine with the holes. Therefore, as long as the high density p-layer on the photoelectric conversion elements functions sufficiently, a main generation source of the white defects is an interface between (i) a region of the silicon substrate, which is located between the photoelectric conversion elements and vertical electric charge transfer paths, and (ii) the gate insulating film.

In a photoelectric conversion element, the exposure time for which is long, a ratio of noise to an amount of signals is so high that an influence of the white defects appears remarkably. On the other hand, in a photoelectric conversion element, the exposure time for which is short, the ratio of noise to an amount of signals is low, and also the white defects which are generated until start of the exposure are reset by the application of the readout pulse. Therefore, in this case, the influence of the white defects less likely causes a problem. As described above, if there is a difference between S/N of the signals obtained from the photoelectric conversion elements, the exposure time for which is long, and S/N of the signals obtained from the photoelectric conversion elements, the exposure time for which is short, due to the influence of the white defects, a quality of a wide dynamic range image, which is obtained by combining image data being generated from the both signals, is deteriorated. Therefore, a countermeasure for the white defects is very important to the solid-state imaging device, which can concurrently obtain two types of imaging signals by controlling the exposure times for the photoelectric conversion elements.

### SUMMARY OF THE INVENTION

The invention has been made in view of the above circumstances and provides an imaging apparatus which is mounted with a solid-state imaging device that can concurrently obtain two types of imaging signals by controlling the exposure times for photoelectric conversion elements and which can reduce noise contained in the imaging signals.

According to an aspect of the invention, an imaging apparatus includes a solid-state imaging device and a driving unit configured to drive the solid-state imaging device. The solid-state imaging device includes a large number of photoelectric conversion elements, electric charge transfer paths and transfer electrodes. The photoelectric conversion elements are arranged two-dimensionally in a specific direction on a semiconductor substrate and in a direction perpendicular to the specific direction. The electric charge transfer paths are disposed to correspond to photoelectric conversion element columns each having the plurality of photoelectric conversion elements being arranged in the specific direction. Each electric charge transfer path transfers in the specific direction electric charges generated by the plurality of photoelectric conversion elements of the corresponding photoelectric conversion element column. The transfer electrodes are disposed above the electric charge transfer paths and are arranged in the specific direction. The transfer electrodes includes first transfer electrodes and second transfer electrodes. The first transfer electrodes are disposed to correspond to the plurality of photoelectric conversion elements of each photoelectric conversion element column, respectively. The first transfer electrodes control (i) reading out of the electric charges from the respective photoelectric conversion elements of each photoelectric conversion element column to the corresponding electric charge transfer path and (ii) transferring of the electric charges in the corresponding electric charge transfer path. The second transfer electrodes control the transferring of the electric charges in the electric charge transfer paths. The large number of photoelectric conversion elements include first photoelectric conversion elements and second photoelectric conversion elements. An exposure time for the second photoelectric conversion elements is controlled to be shorter than that for the first photoelectric conversion elements. To the first photoelectric conversion elements, any of (i) a first transfer pulse for forming packets to accumulate electric charges in the electric charge transfer paths, (ii) a second transfer pulse, having a level lower than that of the first transfer pulse, for forming barriers for the packets in the electric charge transfer paths, and (iii) a readout pulse, having a level higher than that of the first transfer pulse, for reading out the electric charges from the photoelectric conversion elements to the electric charge transfer paths can be applied. Any of the first transfer pulse and the second transfer pulse can be applied to the second transfer electrodes. The driving unit applies the readout pulse to the first transfer electrodes corresponding to the second photoelectric conversion elements during the exposure period for the first photoelectric conversion elements, and upon stop of the reading pulse, the driving unit starts exposing the second photoelectric conversion elements. The driving unit applies the second transfer pulse to all the transfer electrodes during a period from start of exposure of the first photoelectric conversion elements to the applying of the readout pulse.

Also, the driving unit may apply the first transfer pulse to a part of the transfer electrodes including the first and second transfer electrodes during a period from the applying of the readout pulse to an end of the exposure time for the second photoelectric conversion elements.

Also, the part of the transfer electrodes may be at least a part of the transfer electrodes except for the transfer electrodes adjacent to the first photoelectric conversion elements or at least a part of the transfer electrodes except for the first transfer electrodes corresponding to the first photoelectric conversion elements. During the period from the applying of the readout pulse to the end of the exposure time for the second photoelectric conversion elements, the driving unit may apply the second transfer pulse to at least the transfer electrodes adjacent to the first photoelectric conversion elements or the first transfer electrodes corresponding to the first photoelectric conversion elements.

Also, if the set exposure time for the second photoelectric conversion element is longer than a threshold value, after applying the readout pulse, the driving unit may apply the first and second transfer pulses to the transfer electrodes to sweep out electric charges existing in the electric charge transfer paths. After the sweeping out is completed, the driving unit may apply the second transfer pulse to all the transfer electrodes until the end of the exposure period for the second photoelectric conversion elements.

According to another aspect of the invention, a solid-state imaging device includes a large number of photoelectric conversion elements, electric charge transfer paths and transfer electrodes. The photoelectric conversion elements are arranged two-dimensionally in a specific direction on a semiconductor substrate and in a direction perpendicular to the specific direction. The electric charge transfer paths are disposed to correspond to photoelectric conversion element columns each having the plurality of photoelectric conversion elements being arranged in the specific direction. Each electric charge transfer path transfers in the specific direction electric charges generated by the plurality of photoelectric conversion elements of the corresponding photoelectric conversion element column. The transfer electrodes are disposed above the electric charge transfer paths and are arranged in the specific direction. The transfer electrodes include first transfer electrodes and second transfer electrodes The first transfer electrodes are disposed to correspond to the plurality of photoelectric conversion elements of each photoelectric conversion element column, respectively. The first transfer electrodes control (i) reading out of the electric charges from the respective photoelectric conversion elements of each photoelectric conversion element column to the corresponding electric charge transfer path and (ii) transferring of the electric charges in the corresponding electric charge transfer path. The second transfer electrodes control the transferring of the electric charges in the electric charge transfer paths. The large number of photoelectric conversion elements include first photoelectric conversion elements and second photoelectric conversion elements. An exposure time for the second photoelectric conversion elements is controlled to be shorter than that for the first photoelectric conversion elements. To the first photoelectric conversion elements, any of (i) a first transfer pulse for forming packets to accumulate electric charges in the electric charge transfer paths, (ii) a second transfer pulse, having a level lower than that of the first transfer pulse, for forming barriers for the packets in the electric charge transfer paths, and (iii) a readout pulse, having a level higher than that of the first transfer pulse, for reading out the electric charges from the photoelectric conversion elements to the electric charge transfer paths can be applied. Any of the first transfer pulse and the second transfer pulse can be applied to the second transfer electrodes. A method for driving a solid-state imaging device includes: applying the readout pulse to the first transfer electrodes corresponding to the second photoelectric conversion elements during the exposure period for the first photoelectric conversion elements; upon stop of the reading pulse, starting exposing the second photoelectric conversion elements; and applying the second transfer pulse to all the transfer electrodes during a period from start of exposure of the first photoelectric conversion elements to the applying of the readout pulse.

Also, the method may further include applying the first transfer pulse to a part of the transfer electrodes including the first and second transfer electrodes during a period from the applying of the readout pulse to an end of the exposure time for the second photoelectric conversion elements.

Also, the part of the transfer electrodes may be at least a part of the transfer electrodes except for the transfer electrodes adjacent to the first photoelectric conversion elements or at least a part of the transfer electrodes except for the first transfer electrodes corresponding to the first photoelectric conversion elements. The method may further include during the period from the applying of the readout pulse to the end of the exposure time for the second photoelectric conversion elements, applying the second transfer pulse to at least the transfer electrodes adjacent to the first photoelectric conversion elements or the first transfer electrodes corresponding to the first photoelectric conversion elements.

Also the method may further include: if the set exposure time for the second photoelectric conversion element is longer than a threshold value, after applying the readout pulse, applying the first and second transfer pulses to the transfer electrodes to sweep out electric charges existing in the electric charge transfer paths; and after the sweeping out is completed, applying the second transfer pulse to all the transfer electrodes until the end of the exposure period for the second photoelectric conversion elements.

With the above configuration, it is possible to provide an imaging apparatus which is mounted with a solid-state imaging device that can concurrently obtain two types of imaging signals by controlling the exposure times for photoelectric conversion elements and which can reduce noise contained in the imaging signals.

### BRIEF DESCRIPTION OF THE DRAWINGS

Fig. 1 is a view showing an outline of the configuration of a digital camera that is an example of an imaging apparatus with reference to which a first embodiment of the invention is described.
Fig. 2 is a schematic plan view showing an example of the configuration of a solid-state imaging device mounted on the digital camera of the first embodiment of the invention.
Fig. 3 is a timing chart of transfer pulses at a time of photographing with the digital camera of the first embodiment of the invention.
Fig. 4 is a flow chart showing an operation flow at the time of photographing with a digital camera of a second embodiment of the invention.
Fig. 5 is a timing chart showing a driving operation for inserting sweeping out of electric charges, which is executed by the digital camera of the second embodiment of the invention.
Fig. 6 is a schematic plan view showing an example of the configuration of a solid-state imaging device mounted on a digital camera of a third embodiment of the invention.
Fig. 7 is a schematic plan view showing an example of the configuration of a solid-state imaging device mounted on a digital camera of a fourth embodiment of the invention.

### DETAILED DESCRIPTION OF EMBODIMENTS OF THE INVENTION

Referring to the accompanying drawings, embodiments of the invention will be described below.

### (First Embodiment)

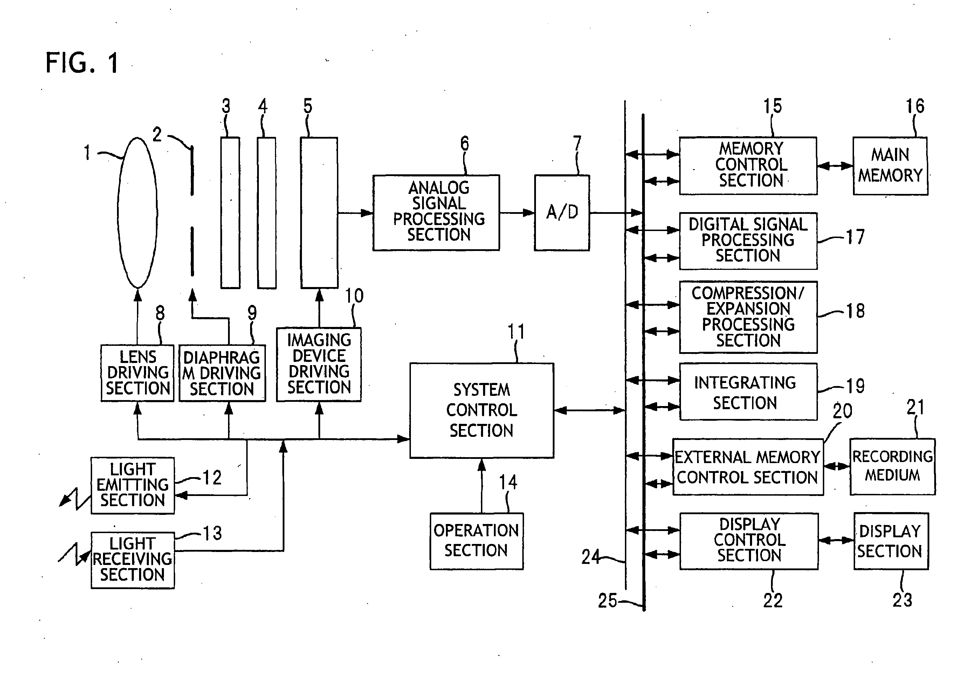

Fig. 1 is a view showing an outline of the configuration of a digital camera that is an example of an imaging apparatus with reference to which a first embodiment of the invention will be described.

A taking-image system of the digital camera shown in the figure includes a taking lens 1, a solid-state imaging device 5, an aperture diaphragm 2 which is arranged between the taking lens 1 and the solid-state imaging device 5, an infrared cut filter 3; and an optical low-pass filter 4.

A system control section 11 for controlling the entire electric controlling system of the digital camera controls a flash light emitting section 12 and a light receiving section 13. The system control section 11 also controls a lens driving section 8 so as to adjust a position of the taking lens 1 to a focusing position and to adjust zooming. Furthermore, the system control section 11 controls the aperture diaphragm 2 through a diaphragm driving section 9 so as to adjust an exposure amount.

The system control section 11 drives the solid-state imaging device 5 through the imaging device driving section 10 and causes the solid-state imaging device 5 to output a photographic object image, which has been photographed through the taking lens 1, as a color signal. A command signal from a user is input through the operation section 14 into the system control section 11.

The electric control system of the digital camera further includes: an analog signal processing section 6 being connected to an output of the solid-state imaging device 5, the analog signal processing section 6 for executing analog signal processing such as a correlative double sampling processing; and an A/D conversion circuit 7 for converting the color signal of RGB output from the analog signal processing section 6 into a digital signal. These components are controlled by the system control section 11.

The electric control system of the digital camera further includes a main memory 16, a memory control section 15 connected to the main memory 16, a digital signal processing section 17 for generating image data by executing an interpolation calculation, a gamma correction calculation, RGB/YC conversion processing and image synthesizing processing; a compression/expansion processing section 18 for compressing image data, which is generated by the digital signal processing section 17, into JPEG form and for expanding the compressed image data; an integrating section 19 for integrating photometry data to obtaining a gain for a white balance correction, which is executed by the digital signal processing section 17, an external memory control section 20 to which a detachable recording medium 21 is connected; and a display control section 22 to which a liquid crystal display section 23 mounted on a rear face of the camera is connected. These components are connected to each other through a control bus 24 and a data bus 25 and controlled by commands given from the system control section 11.

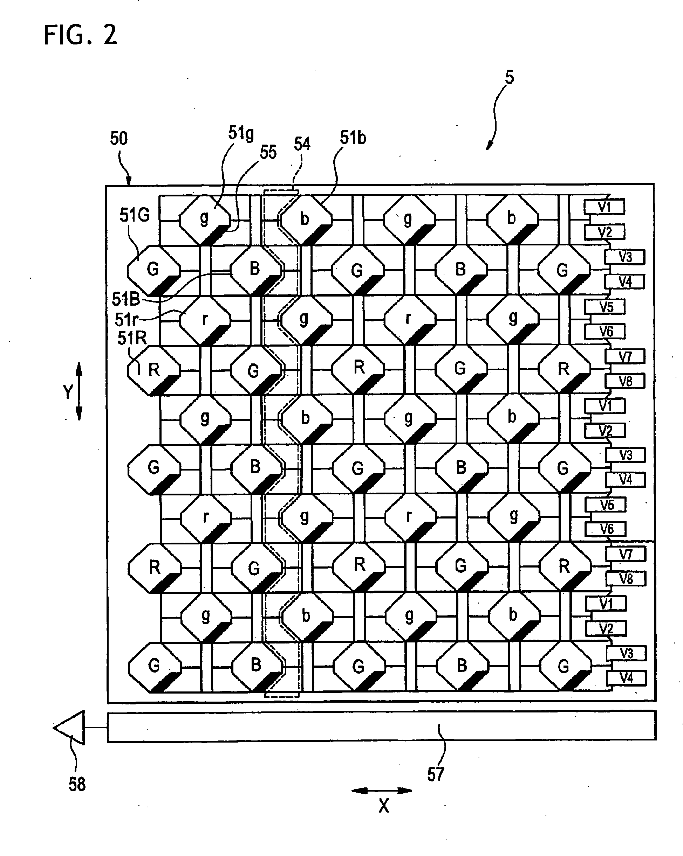

Fig. 2 is a schematic plan view showing an example of the configuration of the solid-state imaging device 5 shown in Fig. 1.

The solid-state imaging device 5 includes an RGB group of photoelectric conversion elements and an rgb group of photoelectric conversion elements. The RGB group includes photoelectric conversion elements 51R (attached with character "R" in the figure) for detecting light (R light) in a wavelength region of red (R), photoelectric conversion elements 51G (attached with character "G" in the figure) for detecting light (G light) in the wavelength region of green (G), and photoelectric conversion elements 51B (attached with character "B" in the figure) for detecting light (B light) in the wavelength region of blue (B). The photoelectric conversion elements 51R, 51G and 51B are arranged on a square grid formed of a row direction X on the semiconductor substrate 50 and a direction Y perpendicular to the row direction X. Also, the rgb group includes photoelectric conversion elements 51r (attached with character "r" in the figure) for detecting light (R light), photoelectric conversion elements 5 1 g (attached with character "g" in the figure) for detecting light (G light), and photoelectric conversion elements 51b (attached with character "b" in the figure) for detecting light (B light). The photoelectric conversion elements 51 r, 51 g and 51 b are arranged on a square grid formed of the row direction X on the semiconductor substrate 50 and the direction Y perpendicular to the row direction X. These groups are respectively arranged in positions which are shifted in the row direction X and the column direction Y by about 1/2 of the photoelectric conversion element arrangement pitch.

Color filters are provided above the photoelectric conversion elements of the RGB group. These color filters are arranged in accordance with the Bayer arrangement. Likewise, color filters are also provided above the photoelectric conversion elements of the rgb group. These color filters are also arranged in accordance with the Bayer arrangement.

The photoelectric conversion elements of the RGB group and the photoelectric conversion elements of the rgb group have the same structure. However, the imaging device driving section 10 controls the exposure times for the respective groups to be different from each other. In this embodiment, the imaging device driving section 10 controls the exposure period for the photoelectric conversion elements of the rgb group are shorter than that for the photoelectric conversion elements of the RGB group.

It can be said that an arrangement of the photoelectric conversion elements of the RGB group is obtained by alternately arranging in the row direction X a GR photoelectric conversion element column formed of the photoelectric conversion elements 51 G and the photoelectric conversion elements 51 R, which are arranged in the column direction Y, and a BG photoelectric conversion element column formed of the photoelectric conversion elements 51B and the photoelectric conversion elements 51G, which are arranged in the column direction Y. Alternatively, it can be said that the arrangement of the photoelectric conversion elements of the RGB group is obtained by alternately arranging in the column direction Y a GB photoelectric conversion element row formed of the photoelectric conversion elements 51G and the photoelectric conversion elements 51B, which are arranged in the row direction X, and an RG photoelectric conversion element row formed of the photoelectric conversion elements 51R and the photoelectric conversion elements 51G, which are arranged in the row direction X.

It can be said that an arrangement of the photoelectric conversion elements of the rgb group is obtained by alternately arranging in the row direction X a gr photoelectric conversion element column formed of the photoelectric conversion elements 51g and the photoelectric conversion elements 51r, which are arranged in the column direction Y, and a bg photoelectric conversion element column formed of the photoelectric conversion elements 51b and the photoelectric conversion elements 51g, which are arranged in the column direction Y. Alternatively, it can be said that the arrangement of the photoelectric conversion elements of the rgb group is obtained by alternately arranging in the column direction Y a gb photoelectric conversion element row formed of the photoelectric conversion elements 5 1 g and the photoelectric conversion elements 51b, which are arranged in the row direction X, and an rg photoelectric conversion element row formed of the photoelectric conversion elements 51r and the photoelectric conversion elements 51g, which are arranged in the row direction X.

On the right side of each photoelectric conversion element column, formed is a vertical electric charge transfer path 54 (Fig. 2 shows only a part of the vertical electric charge transfer path 54) which corresponds to each photoelectric conversion element column and which transfers electric charges accumulated in the photoelectric conversion elements of each photoelectric conversion element column along the column direction Y. The vertical electric charge transfer path 54 is formed of, for example, n-type impurities which are implanted into a p-well layer formed on an n-type silicon substrate.

Transfer electrodes V1 to V8 are formed above the vertical electric charge transfer path 54 to which the imaging device driving section 10 applies 8-phase transfer pulses for controlling transfer of electric charges, which are read out into the vertical electric charge transfer path 54. A transfer pulse φV1 is applied to the transfer electrode V1, a transfer pulse φV2 is applied to the transfer electrode V2, a transfer pulse φV3 is applied to the transfer electrode V3, a transfer pulse φV4 is applied to the transfer electrode V4, a transfer pulse φV5 is applied to the transfer electrode V5, a transfer pulse φV6 is applied to the transfer electrode V6, a transfer pulse φvV7 is applied to the transfer electrode V7, and a transfer pulse φV8 is applied to the transfer electrode V8.

The transfer electrodes V1 to V8 are respectively arranged between the photoelectric conversion element lines, to snake in the row direction X so that the transfer electrodes V1 to V8 avoid the photoelectric conversion elements forming the photoelectric conversion element columns. In an upper side portion of each gb photoelectric conversion element row, the transfer electrode V8 and the transfer electrode V1 are arranged in this order from the adjacent photoelectric conversion element row between the gb photoelectric conversion element row and the adjacent photoelectric conversion element row. In a lower side portion of each gb photoelectric conversion element row, the transfer electrode V2 and the transfer electrode V3 are arranged in order from the gb photoelectric conversion element row between the gb photoelectric conversion element row and the adjacent photoelectric conversion element row. In an upper side portion of each rg photoelectric conversion element row, the transfer electrode V4 and the transfer electrode V5 are arranged in order from the adjacent photoelectric conversion element row side between the rg photoelectric conversion element row and the adjacent photoelectric conversion element row. In a lower side portion of each rg photoelectric conversion element row, the transfer electrode V6 and the transfer electrode V7 are arranged in order from the rg photoelectric conversion element row between the rg photoelectric conversion element row and the adjacent photoelectric conversion element row.

Between each photoelectric conversion element and the corresponding vertical electric charge transfer path 54, an electric charge readout portion 55 is provided. Each electric charge readout portion 55 is used to read out electric charges, which are generated in the corresponding photoelectric conversion element, into the vertical electric charge transfer path 54. The electric charge readout portion 55 is formed of, for example, a p-type impurity layer in the p-well layer formed on the n-type silicon substrate. The electric charge readout portions 55 are arranged in the same direction (in a right oblique direction in the figure) with respect to the corresponding photoelectric conversion elements.

The transfer electrode V2 is formed above the electric charge readout portion 55 corresponding to each photoelectric conversion element of the gb photoelectric conversion element row. When a readout pulse is applied to the transfer electrode V2, an electric charge accumulated in each photoelectric conversion element of the gb photoelectric conversion element row is read out into the vertical electric charge transfer path 54 located on the right side of each photoelectric conversion element.

The transfer electrode V4 is formed above the electric charge readout portion 55 corresponding to each photoelectric conversion element of the GB photoelectric conversion element row. When a readout pulse is applied to the transfer electrode V4, an electric charge accumulated in each photoelectric conversion element of the GB photoelectric conversion element row is read out into the vertical electric charge transfer path 54 located on the right side of each photoelectric conversion element.

The transfer electrode V6 is formed above the electric charge readout portion 55 corresponding to each photoelectric conversion element of the rg photoelectric conversion element row. When a readout pulse is applied to the transfer electrode V6, an electric charge accumulated in each photoelectric conversion element of the rg photoelectric conversion element row is read out into the vertical electric charge transfer path 54 located on the right side of each photoelectric conversion element.

The transfer electrode V8 is formed above the electric charge readout portion 55 corresponding to each photoelectric conversion element of the RG photoelectric conversion element line. When a readout pulse is applied to the transfer electrode V8, an electric charge accumulated in each photoelectric conversion element of the RG photoelectric conversion element line is read out into the vertical electric charge transfer path 54 located on the right side of each photoelectric conversion element.

The vertical electric charge transfer paths 54 are connected to a horizontal electric charge transfer path 57 for transferring the electric charges, which have been transferred in the vertical electric charge transfer path 54, in the row direction X. The horizontal electric charge transfer path 57 is connected to an output amplifier 58 for converting the electric charges, which have been transferred in the horizontal electric charge transfer path 57, into voltage signals and outputting the voltage signals.

Any of a transfer pulse VM of a medium level (VM, for example, 0V) for forming a packet for accumulating an electric charge in the vertical electric charge transfer path 54, a transfer pulse VL of a low level (VL, for example, -8V) lower than VM for forming a barrier for the packet in the vertical electric charge transfer path 54, and a readout pulse for reading out an electric charge from the photoelectric conversion element into the vertical electric charge transfer path 54, a level (VH, for example, 15V) of the readout pulse being higher than VM can be applied to each of the transfer electrodes (V2, V4, V6, V8) located above the electric charge readout portion 55 Also, either the transfer pulse VL or the transfer pulse VM can be applied to each of the transfer electrodes (V1, V3, V5, V7) except for the transfer electrodes (V2, V4, V6, V8) located above the electric charge readout portions 55.

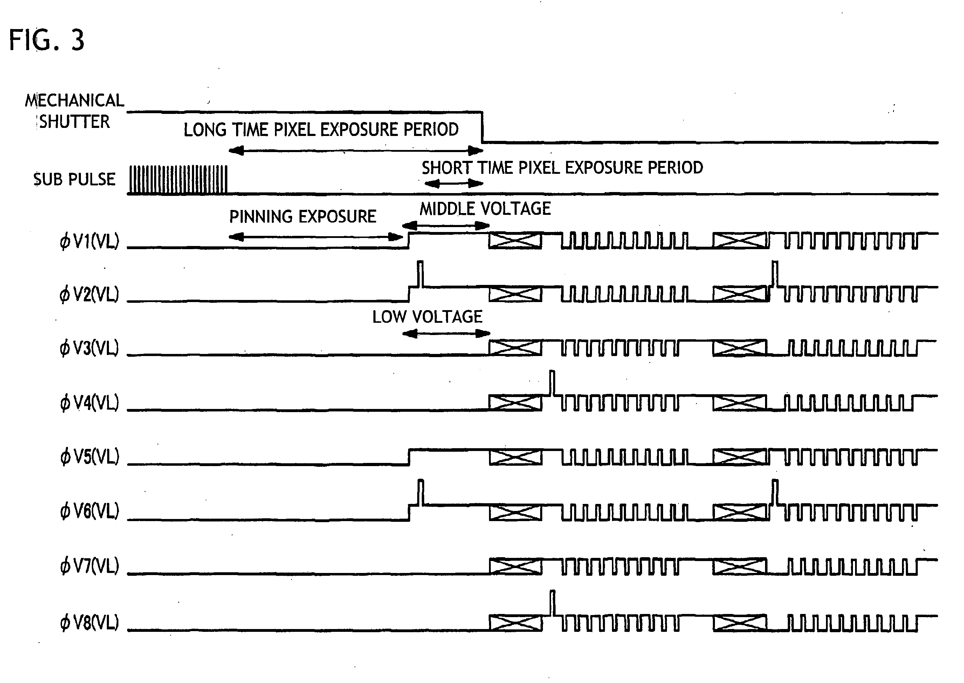

Next, a photographing operation of the digital camera configured as described above will be described below. Fig. 3 is a timing chart of transfer pulses at the time of photographing with the digital camera of the first embodiment.

When a shutter button provided in the operation section 14 is half-pressed, the automatic exposure process (AE) and the automatic focus adjustment process (AF) are performed by the system control section 11, as to as measure a dynamic range necessary for taking a photographic object. The system control section 11 determines an exposure time for the photoelectric conversion element 51R, 51G, 51B and an exposure time for the photoelectric conversion element 51r, 51g, 51b based on the measured dynamic range and controls the imaging device driving section 10 so that an image is taken during the decided exposure time.

As shown in Fig. 3, during a period in which a mechanical shutter (not shown) mounted on the digital camera is opened, when the imaging device driving section 10 stops a supply of electronic shutter pulses (SUB pulses) so that the electronic shutter is opened, an exposure period for the photoelectric conversion element 51R, 51G, 51B is started. At this point of time at which the exposure period is started, transfer pulses of VL are supplied from the imaging device driving section 10 to the transfer electrode V1 to V8.

Immediately before the timing of starting the exposure of the photoelectric conversion element 51r, 5 1 g, 51b, the imaging device driving section 10 sets transfer pulses applied to the transfer electrode V1, V2, V5, V6 to VM. At the timing of starting the exposure of the photoelectric conversion element 51r, 5 1 g, 51b, the imaging device driving section 10 applies the readout pulses of VH to the transfer electrodes V2, V6 so as to read out the electric charges accumulated in the photoelectric conversion elements 51r, 51g, 51b into the vertical electric charge transfer paths 54 through the electric charge readout portions 55. Then, the imaging device driving section 10 executes a driving operation for starting an exposure period for the photoelectric conversion element 51 r, 51 g, 51 b.

After applying the readout pulses, the imaging device driving section 10 returns the transfer pulses φV2, φV6 to VM. When the mechanical shutter is closed and the exposure period for the photoelectric conversion element ends, the imaging device driving section 10 controls transfer pulses to sweep out unnecessary electric charges existing in the vertical electric charge transfer paths 54 at a high speed. After the completion of the sweeping out of the unnecessary electric charges, the imaging device driving section 10 applies the readout pulses to the transfer electrodes V4, V8 so as to read out the electric charges accumulated in the photoelectric conversion elements 51R, 51G, 51B into the vertical electric charge transfer paths 54. Then, the imaging device driving section 10 controls the transfer pulses to transfer the readout electric charges into the horizontal electric charge transfer path 57 and further transfer the electric charges to the output amplifier 58 by the horizontal electric charge transfer path 57. Thereby, signals corresponding to the electric charges accumulated in the photoelectric conversion elements 51R, 51G, 51 B are output from the solid-state imaging device 5.

Next, the imaging device driving section 10 controls the transfer pulses to sweep out unnecessary electric charges existing in the vertical electric charge transfer path 54 at a high speed. After the completion of the sweeping out of the unnecessary electric charges, the imaging device driving section 10 applies the readout pulses to the transfer electrodes V2, V6 so as to read out electric charges accumulated in the photoelectric conversion elements 51r, 51g, 51b into the vertical electric charge transfer path 54s. Then, the imaging device driving section 10 controls the transfer pulses to transfer the readout electric charges into the horizontal electric charge transfer path 57 and further transfer the electric charges to the output amplifier 58 by the horizontal electric charge transfer path 57. Thereby, signals corresponding to the electric charges accumulated in the photoelectric conversion elements 51r, 51g, 51b are output from the solid-state imaging device 5.

The digital signal processing section 17 generates image data based on the signals obtained from the photoelectric conversion elements 51 R, 51G, 51B and also generates image data based on the signals obtained from the photoelectric conversion element 51r, 51g, 51b. These two image data are combined to generate combined image data having the dynamic range extended, and the combined image data is output to the compression/expansion processing section 18. The compression/expansion processing section 18 performs a compression process for the combined image data. Then, the compressed combined image data is recorded in the recording medium 21, and the photographing operation is finished.

According to the driving operation described above, in the period from the start of the exposure period for the photoelectric conversion elements 51R, 51G, 51 B to the start of the exposure period for the photoelectric conversion elements 51r, 51g, 51b, the transfer pulses of VL are supplied to the respective transfer electrodes V1 to V8. Therefore, electrons generated on the interface between (i) the region of the silicon substrate 50, which is located between each photoelectric conversion element and the vertical electric charge transfer path 54 and (ii) the gate insulating film above the region can be accumulated in the region without being moved to each of the photoelectric conversion elements 51R, 51G, 51 B. This is because when a transfer pulse being negative in polarity is applied to the transfer electrode above the region, holes are accumulated in the region, and these holes and the electrons generated on the above interface are recombined with each other. Thereby, it becomes possible to accumulate the electrons in this region. As a result, it is possible to reduce the generation of white defects in the photoelectric conversion elements 51 R, 51G, 51B.

According to the driving operation described above, after the readout pulses are applied, packets are formed in the vertical electric charge transfer paths 54 below the transfer electrodes V1, V2, V5, V6. Therefore, smear electric charges, which are generated in the vertical electric charge transfer paths 54 during the period from the start of the exposure of the photoelectric conversion element 51 R, 51G, 51 B to the application of the readout pulses, and smear electric charges, which are generated in the vertical electric charge transfer path 54 during the period from the application of the readout pulses to the end of the exposure period for the photoelectric conversion element 51 R, 51G, 51 B, are held in these packets without being moved to the photoelectric conversion elements. Accordingly, these packets suppress generation of blooming that is caused due to generation of a large amount of smear electric charges. Since an amount of smear electric charges increase in proportion to the exposure time, if the photoelectric conversion elements, the exposure time for which is long, exist as in the solid-state imaging device of this embodiment, this phenomenon may particularly cause a problem. Therefore, making packets in the vertical electric charge transfer path 54 after the completion of the applying of the readout pulses is an effective countermeasure against the blooming caused by the smear electric charges. Furthermore, when the driving operation described above is executed, unnecessary electric charges which are accumulated in the photoelectric conversion elements 51 r, 51 g, 51b before the application of the readout pulses can also be held in the above packets together with the above smear electric charges.

In this embodiment, during the period from the start of the exposure of the photoelectric conversion elements 51R, 51G, 51B to the start of the exposure of the photoelectric conversion elements 51r, 5 1 g, 51b, the transfer pulses of VL are applied to the transfer electrodes V1 to V8. Therefore, there is a possibility that the smear electric charge generated during this period may cause blooming. However, if the exposure time for the photoelectric conversion element 51r, 51g, 51b is not extremely shortened, only after the start of the exposure of the photoelectric conversion elements 51r, 51 g, 51b, an amount of smear electric charges may increase to an extent that blooming is caused. Therefore, blooming is less likely caused before the start of the exposure of the photoelectric conversion elements 51 r, 51g, 51b. Accordingly, in order to prevent the white defects, it is effective that the transfer pulses of VL are applied to the transfer electrodes V1 to V8 before the start of the exposure of the photoelectric conversion element 51r, 51g, 51b.

When photoelectric conversion elements of a solid-state imaging device having a general structure are exposed for a long time, a related art adopts a method of applying transfer pulses of VL to all the electrodes above a vertical electric charge transfer paths during the long time exposure. In this method, it is concerned that blooming is caused by smear electric charges which are generated during this exposure period. In the digital camera of this embodiment, even if the exposure period for the photoelectric conversion elements 51 R, 51G, 51 B is set to be the same as the exposure time which is used in the long time exposure for the solid-state imaging device of the related art, after the completion of the application of the readout pulses, the smear electric charges, which are generated so far, and the smear electric charges, which is generated from now on, are held in the packets of the vertical electric charge transfer paths 54. Therefore, the possibility of the occurrence of blooming can be greatly reduced as compared with the related art.

In this embodiment, in order to prevent the occurrence of the white defects from being generated in the photoelectric conversion elements 51 R. 51G, 51 B, after the readout pulses are applied, the imaging device driving section 10 applies the transfer pulses of VL to the transfer electrodes adjacent to the photoelectric conversion elements 51R, 51G, 51B and also applies the transfer pulses of VM to the other transfer electrodes. Even if the transfer pulses of VL are applied only to the transfer electrodes V4, V8 located above the electric charge readout portions 55 corresponding to the photoelectric conversion elements 51R, 51G, 51B, it is possible to obtain the advantage of preventing the occurrence of white defects.

Regions between the photoelectric conversion elements and the vertical electric charge transfer paths 54 include two portions. That is, one is a portion where the electric charge readout portion 55 exists, and the other is a portion where the electric charge readout portion 55 does not exist. When the transfer pulse of VM is applied to them, an electric potential in the portion where the electric charge readout portion 55 does not exist is lower than that in the portion where the electric charge readout portion 55 exists. The portion where the electric charge readout portion 55 does not exist is in a state where some holes are accumulated there. That is, the portion where the electric charge readout portion 55 does not exist has an advantage of preventing white defects. Therefore, even if just the transfer pulses of VL are applied to the transfer electrodes V4, V8, it is possible to provide a sufficiently high effect of preventing the occurrence of white defects.

In this embodiment, after the completion of the application of the readout pulses, the packets are formed in the vertical electric charge transfer paths 54 below the transfer electrodes V1, V2, V5, V6. At least only one packet may be formed in the vertical electric charge transfer paths 54 below the transfer electrodes except for the transfer electrodes V3, V4, V7, V8 to which the transfer pulse of VL is applied. A position at which the packet is formed is not particularly limited. That is, after the completion of the application of the readout pulse, the transfer pulse of VM may be applied to a part of V1, V2, V5, V6, and the transfer pulses of VL may be applied to the other electrodes. Alternatively, after the completion of the application of the readout pulse, the imaging device driving section 10 may apply transfer pulses of VL to the transfer electrodes V4, V8, apply the transfer pulses of VM to a part of the transfer electrodes except for the transfer electrodes V4, V8 and apply the transfer pulses of VL to the remaining transfer electrodes. Further alternatively, after the completion of the application of the readout pulse, the imaging device driving section 10 may apply the transfer pulses of VL only to the transfer electrodes V4, V8 and also apply the transfer pulses of VM to all the transfer electrodes but the transfer electrodes V4, V8.

In this embodiment, after the completion of the application of the readout pulses, in order to prevent the white defects, the transfer pulses of VL are applied to the transfer electrode V3, V4, V7, V8 or the transfer electrode V4, V8. However, in the case of neglecting the effect of preventing the occurrence of white defects, a transfer electrode to which the transfer pulse of VL is applied is not limited thereto. After the completion of the application of the readout pulses, in order to prevent the occurrence of blooming, it is necessary to form packets by applying the transfer pulses of VM to a part of the transfer electrodes V1 to V8. Therefore, the transfer pulses of VL are applied to the transfer electrodes except for the transfer electrodes to which the transfer pulses for forming the packets are applied.

### (Second Embodiment)

The configuration of a digital camera explained according to a second embodiment is the same as that shown in Fig. 1 and therefore will be described with reference to Figs. 1 and 2.

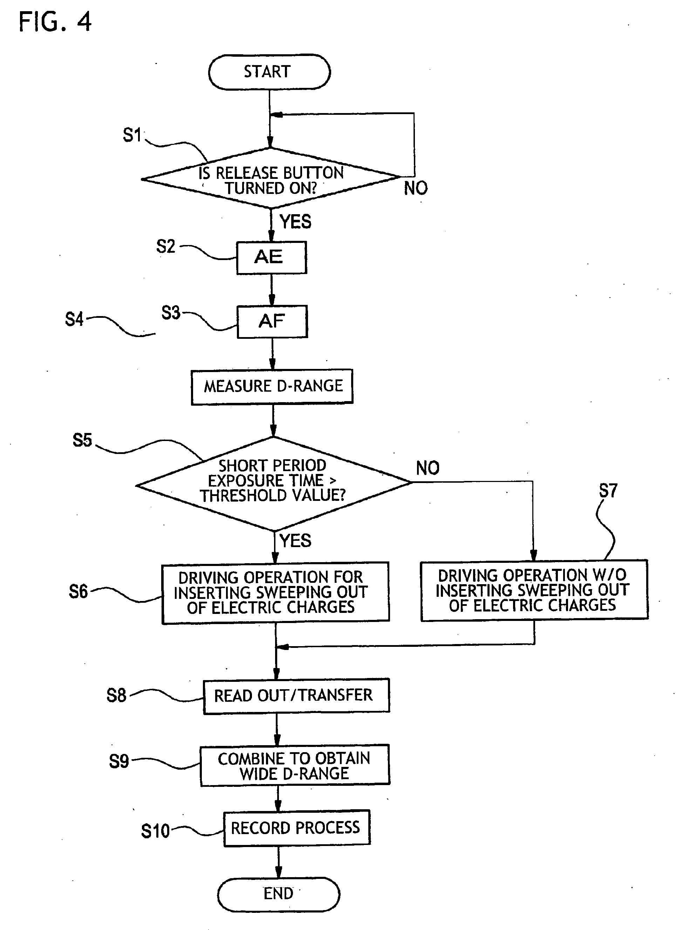

The photographing operation of the digital camera of this embodiment will be described below. Fig. 4 is a flow chart showing an operation executed at a time of photographing with the digital camera of the second embodiment.

When a shutter button provided in the operation section 14 is half-pressed (step S1), the system control section 11 performs the automatic exposure process (AE) (step S2) and the automatic focus adjustment process (AF) (step S3), and also measure a dynamic range necessary for photographing a photographic object (step S4). The system control section 11 determines an exposure time for the photoelectric conversion element 51R, 51G, 51B and an exposure time for the photoelectric conversion element 51 r, 51 g, 51 b based on the measured dynamic range and controls the imaging device driving section 10 so that an image is taken for the determined exposure time.

Next, the system control section 11 judges as to whether or not the exposure period for the photoelectric conversion elements 51 r, 51 g, 51 b is longer than a threshold value (step S5). If the exposure period for the photoelectric conversion elements 51r, 51g, 51b is longer than the threshold value (step S5: YES), in the driving operation explained in the first embodiment, after the application of the readout pulse, the system control section 11 applies transfer pulses of VL and transfer pulses of VM to the transfer electrodes V1 to V8 to sweep out the electric charges existing in the vertical electric charge transfer paths 54. Then, the system control section 11 performs a driving operation for inserting sweeping out of electric charges to apply transfer pulses of VL to all the transfer electrodes V1 to V8 from the completion of the sweeping out of the electric charges until the end of the exposure period for the photoelectric conversion elements 51r, 51g, 51b (step S6).

The driving operation for inserting the sweeping out of the electric charges will be described in detail below.

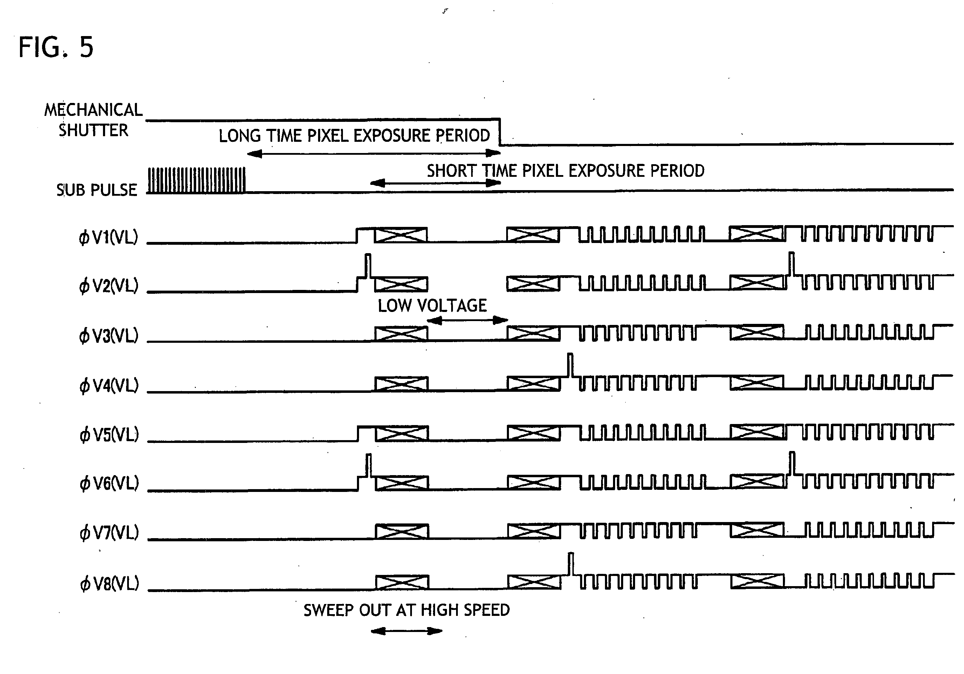

As shown in Fig. 5, during the period in which the mechanical shutter (not shown) mounted on the digital camera is opened, when the imaging device driving section 10 stops a supply of the electronic shutter pulse (SUB pulse) so that the electronic shutter is opened, the exposure period for the photoelectric conversion elements 51R, 51Q 51B is started. At this point of time at which the exposure time is started, transfer pulses of VL are respectively supplied from the imaging device driving section 10 to the transfer electrodes V1 to V8.

Immediately before a timing of starting the exposure of the photoelectric conversion element 51 r, 51 g, 51 b, the transfer pulses applied to the transfer electrode V1, V2, V5, V6 are controlled to be VM by the imaging device driving section 10. Then, At the timing of starting the exposure of the photoelectric conversion element 51r, 51g, 51b, the imaging device driving section 10 applies the readout pulses of VH to the transfer electrodes V2, V6 to read out electric charges accumulated in the photoelectric conversion elements 51r, 51g, 51b into the vertical electric charge transfer paths 54 through the electric charge readout portions 55, and executes the driving operation for starting the exposure period for the photoelectric conversion elements 51r, 51g, 51b.

After the completion of the application of the readout pulses, the imaging device driving section 10 returns the transfer pulses φV2, φV6 to VM. Then, the imaging device driving section 10 applies the transfer pulses of VL and VM to the transfer electrodes V1 to V8 in a predetermined pattern so that the electric charges existing in the vertical electric charge transfer paths 54 are transferred to the horizontal electric charge transfer path 57 and swept out. After the electric charges are swept out, the imaging device driving section 10 applies the transfer pulses of VL to the transfer electrode V1 to V8. The driving operation for inserting the sweeping out of the electric charges is described above.

Referring back to the description of Fig. 4, if the exposure period for the photoelectric conversion elements 51r, 51g, 51b is equal to or less than the threshold value (step S5: NO), the system control section 11 performs the driving operation without inserting the sweeping out of the electric charges shown in Fig. 3 of the first embodiment (step S7) (that is, such a driving operation in which φV1, φV2, φV5 and φV6 are set to VM and φV3, φV4, φV7 and φV8 are set to VL from the application of the readout pulses until the mechanical shutter is closed.).

When steps S6 or S7 is completed, when the mechanical shutter is closed and when the exposure period for photoelectric conversion elements is ended, the imaging device driving section 10 controls the transfer pulses to sweep out unnecessary electric charges existing in the vertical electric charge transfer elements 54 at a high speed. After the completion of the sweeping out of the electric charges, the imaging device driving section 10 applies the readout pulses to the transfer electrodes V4, V8 to read out the electric charges accumulated in the photoelectric conversion elements 51R, 51G, 51B into the vertical electric charge transfer paths 54. Then, the imaging device driving section 10 controls the transfer pulses to transfer the readout electric charges to the horizontal electric charge transfer path 57 and to further transfer the electric charges to the output amplifier 58 by the horizontal electric charge transfer path 57 (step S8). Thereby, signals corresponding to the electric charges accumulated in the photoelectric conversion elements 51 R, 51G, 51 B are output from the solid-state imaging device 5.

Next, the imaging device driving section 10 controls the transfer pulses to sweep out unnecessary electric charges existing in the vertical electric charge transfer elements 54 at a high speed. After the completion of the sweeping out of the electric charges, the imaging device driving section 10 applies the readout pulses to the transfer electrodes V2, V6 to read out the electric charges accumulated in the photoelectric conversion elements 51r, 51g, 51b into the vertical electric charge transfer paths 54. Then, the imaging device driving section 10 controls the transfer pulses to transfer the readout electric charges to the horizontal electric charge transfer path 57 and further transfer the electric charges to the output amplifier 58 by the horizontal electric charge transfer path 57 (step S8). Thereby, signals corresponding to the electric charges accumulated in the photoelectric conversion elements 51r, 5 1 g, 51b are output from the solid-state imaging device 5.

The digital signal processing section 17 generates image data based on the signals obtained from the photoelectric conversion elements 51R, 51G, 51B and also generates image data based on the signals obtained from the photoelectric conversion elements 51r, 51g, 51b. Then, the digital signal processing section 17 combines these two image data to generate combined image data in which the dynamic range is extended (step S9). The combined image data is output to the compression/expansion processing section 18. The compression/expansion processing section 18 compresses the combined image data. Then, the compressed combined image data is recorded in the recording medium 21 (step S10). In this way, the photographing operation is completed.

As described above, in the digital camera of this embodiment, if the exposure period for the photoelectric conversion elements 51r, 51 g, 51b is longer than the threshold value, after the readout pulses for starting the exposure of the photoelectric conversion element 51r, 51g, 51b are applied, the driving operation is executed so that the electric charges, which are read out into the vertical electric charge transfer paths 54 by the readout pulses, and smear electric charges, which are generated in the vertical electric charge transfer paths 54 before the readout pulses are applied, are swept out at the high speed. Since the driving operation for sweeping out the electric charges is inserted, it is unnecessary to form packets for preventing the occurrence of blooming in the vertical electric charge transfer paths 54 after the electric charges are swept out. Therefore, it becomes possible to apply the transfer pulses of VL to the respective transfer electrodes V1 to V8 during the remaining exposure period after the electric charges are swept out. Therefore, white defects are prevented from being generated in this exposure period.

In the digital camera of this embodiment, if the exposure period for the photoelectric conversion elements 51r, 51g, 51b is equal to or less than the threshold value, the driving operation described in the first embodiment is executed. The insertion of the driving operation for sweeping out the electric charges cannot be executed unless the exposure period for the photoelectric conversion elements 51r, 51g, 51b is longer than the time necessary for sweeping out the electric charges. Therefore, the threshold value is set to the time necessary for sweeping out the electric charges, and if the exposure period for the photoelectric conversion elements 51r, 51g, 51b is equal to or less than the threshold value, the driving operation explained in the first embodiment is executed without the driving operation for sweeping out the electric charges being executed. Thereby, the most appropriate driving operation corresponding to the photographing condition can be carried out.

### (Third Embodiment)

In the first and second embodiments, the photoelectric conversion elements of the solid-state imaging devices 5 are arranged in a so-called honeycomb arrangement in which an RGB group of photoelectric conversion elements and an rgb group of photoelectric conversion elements are shifted in the row direction X and the column direction Y by 1/2 of the arrangement pitch. However, the arrangement of the photoelectric conversion elements is not limited to this specific example. For example, the photoelectric conversion elements may be arranged in a square grid. In this embodiment, another configuration example of the solid-state imaging device will be described.

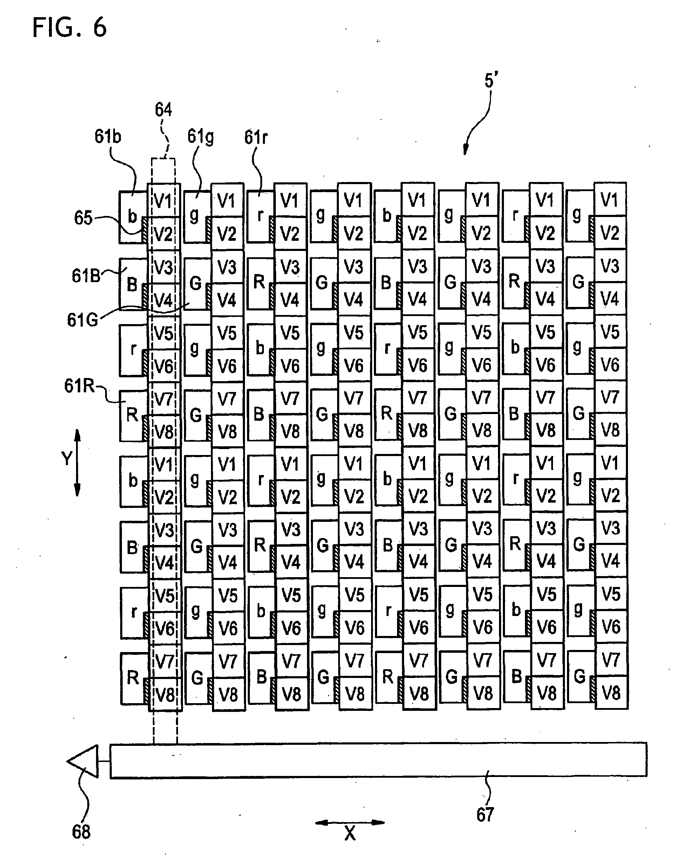

Fig. 6 is a schematic plan view showing another example of the configuration of the solid-state imaging devices mounted on the digital camera shown in Fig. 1.

A solid-state imaging device 5' shown in Fig. 6 includes an RGB group of photoelectric conversion elements and an rgb group of photoelectric conversion elements. The RGB group includes photoelectric conversion elements 61R (attached with "R" in the figure) for detecting R light, photoelectric conversion elements 61 G (attached with "G" in the figure) for detecting G light; and photoelectric conversion elements 61B (attached with "B" in the figure) for detecting light B. The photoelectric conversion elements 61R, 61G and 61B are arranged on a semiconductor substrate in a grid shape formed of the row direction X and the direction Y perpendicular to the row direction X. The rgb group includes photoelectric conversion elements 61r (attached with "r" in the figure) for detecting R light, photoelectric conversion elements 61 g (attached with "g" in the figure) for detecting G light; and photoelectric conversion elements 61b (attached with "b" in the figure) for detecting B light. The photoelectric conversion elements 61r, 61g and 61b are arranged on the semiconductor substrate in a grid shape formed of the row direction X and the direction Y perpendicular to the row direction X. The RGB group and the rgb group are arranged at positions shifted in the column direction Y by about 1/2 of the column direction arrangement pitch of the photoelectric conversion elements.

The photoelectric conversion elements of the RGB group and the photoelectric conversion elements of the rgb group have the same structure. However, the imaging device driving section 10 controls the exposure times for the respective groups to be different from each other. In this embodiment, the imaging device driving section 10 controls the exposure period for the photoelectric conversion elements of the rgb group are shorter than that for the photoelectric conversion elements of the RGB group.

An arrangement of the photoelectric conversion elements of the solid-state imaging device 5' is obtained by repeatedly arranging in the column direction Y in the following order: (i) a bgrg photoelectric conversion element row, which is formed of the photoelectric conversion elements 61b, the photoelectric conversion elements 61g and the photoelectric conversion elements 61r and in which combination of the photoelectric conversion element 61b, the photoelectric conversion element 61g, the photoelectric conversion element 61r and the photoelectric conversion element 61 g, which are arranged in this order in the row direction X, is repeatedly arranged in the row direction X, (ii) a BGRG photoelectric conversion element row, which is formed of the photoelectric conversion elements 61 B, the photoelectric conversion elements 61G and the photoelectric conversion elements 61R, and in which a combination of the photoelectric conversion element 61B, the photoelectric conversion element 61G, the photoelectric conversion element 61R and the photoelectric conversion element 61G, which are arranged in this order in the row direction X, is repeatedly arranged in the row direction X, (iii) an rgbg photoelectric conversion element row, which is formed of the photoelectric conversion elements 61b, the photoelectric conversion elements 61 g and the photoelectric conversion elements 61r, and in which a combination of the photoelectric conversion element 61r, the photoelectric conversion element 61g, the photoelectric conversion element 61b and the photoelectric conversion element 61g, which are arranged in this order in the row direction X, is repeatedly arranged in the row direction X, and (iv) an RGBG photoelectric conversion element row, which is formed of the photoelectric conversion elements 61B, the photoelectric conversion elements 61G and the photoelectric conversion elements 61R, and in which a combination of the photoelectric conversion element 61R, the photoelectric conversion element 61G, the photoelectric conversion element 61 B and the photoelectric conversion element 61G, which are arranged in this order in the row direction X, is repeatedly arranged in the row direction X.

On the right side of each photoelectric conversion element column, which is formed of the photoelectric conversion elements being arranged in the column direction Y, formed is a vertical electric charge transfer path 64 (Fig. 6 shows only a part of the vertical electric charge transfer path 64) which correspond to each photoelectric conversion element column and which transfers electric charges accumulated in the photoelectric conversion elements of each photoelectric conversion element column along the column direction Y. The vertical electric charge transfer path 64 is formed of, for example, n-type impurities which are implanted into a p-well layer formed on an n-type silicon substrate.

Between each photoelectric conversion element and the corresponding vertical electric charge transfer path 64, an electric charge readout portion 65 is provided. Each electric charge readout portion 65 is used to read out electric charges, which are generated in the corresponding photoelectric conversion element, into the vertical electric charge transfer path 64. The electric charge readout portion 65 is formed of, for example, a part of the p-well layer formed on the n-type silicon substrate. The electric charge readout portion 65 is arranged at the same position with respect to each photoelectric conversion element.

Above the vertical electric charge transfer paths 64, the transfer electrodes V1 to V8 are formed to which the imaging device driving section 10 applies 8-phase transfer pulses for controlling the transfer of the electric charges read out into the vertical electric charge transfer paths 64. A transfer pulse φV1 is applied to the transfer electrodes V1, a transfer pulse φV2 is applied to the transfer electrodes V2, a transfer pulse φV3 is applied to the transfer electrodes V3, a transfer pulse φV4 is applied to the transfer electrodes V4, a transfer pulse φV5 is applied to the transfer electrodes V5, a transfer pulse φV6 is applied to the transfer electrodes V6, a transfer pulse φV7 is applied to the transfer electrodes V7, and a transfer pulse φV8 is applied to the transfer electrodes V8.

The transfer electrodes V1, V2 are provided corresponding to the photoelectric conversion elements forming the bgrg photoelectric conversion element rows. The transfer electrodes V2 are formed so that they cover the electric charge readout portions 65 corresponding to the photoelectric conversion elements forming the bgrg photoelectric conversion element rows. When the readout pulses are applied thereto, the electric charges accumulated in the photoelectric conversion elements of the bgrg photoelectric conversion element rows are read out into the vertical electric charge transfer paths 64 being arranged on the right side thereof.

The transfer electrodes V3, V4 are provided corresponding to the photoelectric conversion elements forming the BGRG photoelectric conversion element rows. The transfer electrodes V4 are formed so that they cover the electric charge readout portions 65 corresponding to the photoelectric conversion elements forming the BGRG photoelectric conversion element rows. When the readout pulses are applied thereto, the electric charges accumulated in the photoelectric conversion elements of the BGRG photoelectric conversion element rows are read out into the vertical electric charge transfer paths 64 being arranged on the right side thereof.

The transfer electrodes V5, V6 are provided corresponding to the photoelectric conversion elements forming the rgbg photoelectric conversion element rows. The transfer electrodes V6 are formed so that they cover the electric charge readout portions 65 corresponding to the photoelectric conversion elements forming the rgbg photoelectric conversion element rows. When the readout pulses are applied thereto, the electric charges accumulated in the photoelectric conversion elements of the rgbg photoelectric conversion element rows are read out into the vertical electric charge transfer paths 64 being arranged on the right side thereof.

The transfer electrodes V7, V8 are provided corresponding to the photoelectric conversion elements forming the RGBG photoelectric conversion element rows. The transfer electrodes V8 are formed so that they cover the electric charge readout portions 65 corresponding to the photoelectric conversion elements forming the RGBG photoelectric conversion element rows. When the readout pulses are applied thereto, the electric charges accumulated in the photoelectric conversion elements of the RGBG photoelectric conversion element rows are read out into the vertical electric charge transfer paths 64 being arranged on the right side thereof.

The vertical electric charge transfer paths 64 are connected to the horizontal electric charge transfer path 67 for transferring the electric charges, which have been transferred in the vertical electric charge transfer path 64, in the row direction X. The horizontal electric charge transfer path 67 is connected to the output amplifier 68 for converting the electric charges, which has been transferred in the horizontal electric charge transfer path 67, into voltage signals and outputting the voltage signals.

A photographing operation of the digital camera configured as described above will be described below.

During a period in which a mechanical shutter (not shown) mounted on the digital camera is opened, when the imaging device driving section 10 stops a supply of the electronic shutter pulse (SUB pulse) so that the electronic shutter is opened, an exposure period for the photoelectric conversion elements 61R, 61G, 61B is started. At this point of time at which the exposure period is started, transfer pulses of VL are supplied from the imaging device driving section 10 to the respective transfer electrodes V1 to V8.

Immediately before the timing of starting exposure of the photoelectric conversion element 61r, 61g, 61b, the imaging device driving section 10 sets transfer pulses applied to the transfer electrode V1, V2, V5, V6 to VM. At the timing of starting exposure of the photoelectric conversion element 61r, 61g, 61b, the imaging device driving section 10 applies readout pulses of VH to the transfer electrodes V2, V6 so as to read out the electric charges accumulated in the photoelectric conversion elements 61r, 61g, 61b into the vertical electric charge transfer paths 64 through the electric charge readout portions 65. Then, the imaging device driving section 10 executes the driving operation for starting the exposure period for the photoelectric conversion element 61r, 61g, 61b.

After the completion of the application of the readout pulses, the imaging device driving section 10 returns the transfer pulses φV2, φV6 to VM. When the mechanical shutter is closed and when the exposure period for the photoelectric conversion elements ends, the imaging device driving section 10 controls transfer pulses so as to sweep out unnecessary electric charges existing in the vertical electric charge transfer paths 64 at a high speed. After the completion of the sweeping out of the electric charges, the imaging device driving section 10 applies the readout pulses to the transfer electrodes V4, V8 so as to read out the electric charges accumulated in the photoelectric conversion elements 61R, 61G, 61B into the vertical electric charge transfer paths 64. Then, the imaging device driving section 10 controls the transfer pulses to transfer the readout electric charges to the horizontal electric charge transfer path 67 and then further transfer the electric charges to the output amplifier 68 by the horizontal electric charge transfer path 67. Thereby, signals corresponding to the electric charges accumulated in the photoelectric conversion elements 61R, 61G, 61B are output from the solid-state imaging device 5'.

Next, the imaging device driving section 10 controls transfer pulses so as to sweep out unnecessary electric charges existing in the vertical electric charge transfer paths 64 at a high speed. After the completion of the sweeping out of the electric charges, the imaging device driving section 10 applies the readout pulses to the transfer electrodes V2, V6 so as to read out the electric charges accumulated in the photoelectric conversion elements 61r, 61g, 61b into the vertical electric charge transfer paths 64. Then, the imaging device driving section 10 controls the transfer pulses so as to transfer the readout electric charges to the horizontal electric charge transfer path 67 and then further transfer the electric charges to the output amplifier 68 by the horizontal electric charge transfer path 67. Thereby, signals corresponding to the electric charges accumulated in the photoelectric conversion elements 61r, 61g, 61b are output from the solid-state imaging device 5'.

The digital signal processing section 17 generates image data based on the signals obtained from the photoelectric conversion element 61R, 61G, 61B and also generates image data based on the signals obtained from the photoelectric conversion elements 61r, 61g, 61b. The digital signal processing section 17 combines these two image data to generate combined image data in which the dynamic range is extended. Then, the digital signal processing section 17 outputs the combined image data to the compression/expansion processing section 18. The compression/expansion processing section 18 performs the compression process for the combined image data. The compressed combined image data is recorded in the recording medium 21, and the photographing operation is finished.

As described above, even if the solid-state imaging device is configured as shown in Fig. 6, the driving operation can be executed in the same manner as that of the first embodiment, and the same effect can be achieved. In this connection, even in this embodiment, as described in the second embodiment, if the exposure time for the photoelectric conversion element 61r, 61g, 61b is longer than the threshold value, electric charges may be swept out after the completion of the application of the readout pulses, and then the transfer pulses of VL may be applied to the respective transfer electrodes V1 to V8 until the mechanical shutter is closed.

### (Fourth Embodiment)

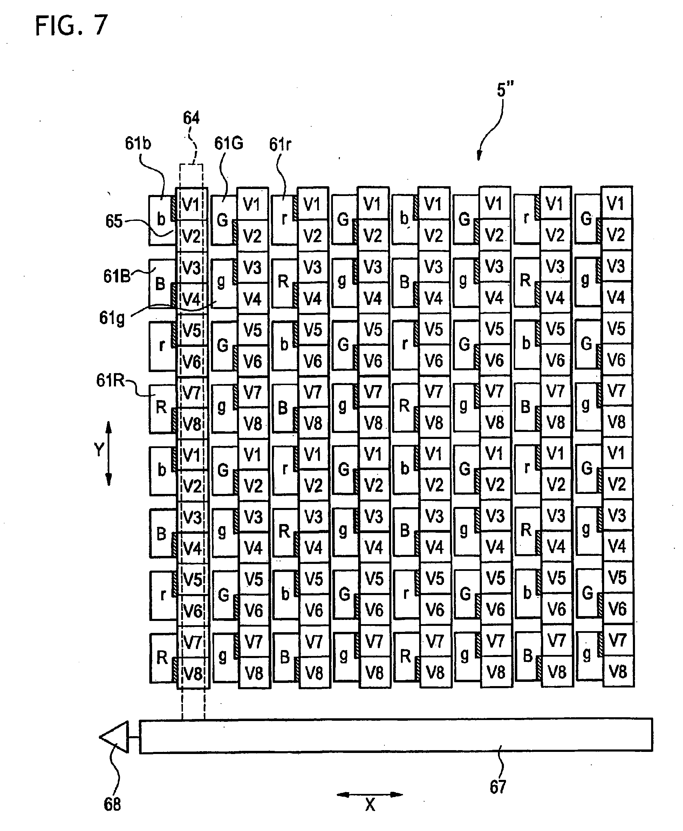

Fig. 7 is a schematic plan view showing further another example of the configuration of the solid-state imaging device mounted on the digital camera shown in Fig. 1.

A solid-state imaging device 5" shown in Fig. 7 is configured in such a manner that the positions of the photoelectric conversion elements 61G and the positions of the photoelectric conversion elements 61g adjacent to the photoelectric conversion elements 61 G on the opposite side to the horizontal electric charge transfer path 67 are switched to each other in the solid-state imaging device shown in Fig. 6. The solid-state imaging device 5" shown in Fig. 7 is also configured in such a manner that the positions of the electric charge readout portions 65, which are provided to correspond to the photoelectric conversion elements 61 G shown in Fig. 6 and are disposed below the transfer electrodes V4, are changed to positions below the transfer electrodes V3 adjacent to the transfer electrodes V4 and that the positions of the electric charge readout portion 65 , which are provided to correspond to the photoelectric conversion elements 61G shown in Fig. 6 and are disposed below the transfer electrodes V8, are changed to positions below the transfer electrodes V7 adjacent to the transfer electrodes V8. Furthermore, the positions of the electric charge readout portions 65, which are provided to correspond to the photoelectric conversion elements 61r, 61b shown in Fig. 6 and are disposed below the transfer electrodes V2, are changed to positions below the transfer electrodes V1 adjacent to the transfer electrodes V2 and that the positions of the electric charge readout portions 65 which are provided correspond to the photoelectric conversion elements 61r, 61b shown in Fig. 6 and are disposed below the transfer electrodes V6, are changed to positions below the transfer electrodes V5 adjacent to the transfer electrodes V6.

The transfer electrodes V1 and the transfer electrodes V5 cover the electric charge readout portions 65 corresponding to the photoelectric conversion elements 61r, 61b. Therefore, when the readout pulses are applied to the transfer electrodes V 1 and the transfer electrodes V5, the electric charges accumulated in the photoelectric conversion elements 61r, 61b are read out into the vertical electric charge transfer paths 64 located on the right side thereof.

The transfer electrodes V3 and the transfer electrodes V7 cover the electric charge readout portions 65 corresponding to the photoelectric conversion elements 61g. Therefore, when the readout pulses are applied to the transfer electrodes V3 and the transfer electrodes V7, the electric charges accumulated in the photoelectric conversion elements 61 g are read out into the vertical electric charge transfer paths 64 located on the right side thereof.

The transfer electrodes V2 and the transfer electrodes V6 cover the electric charge readout portions 65 corresponding to the photoelectric conversion elements 61G. Therefore, when the readout pulses are applied to the transfer electrodes V2 and the transfer electrodes V6, the electric charge accumulated in the photoelectric conversion elements 61 G are read out into the vertical electric charge transfer paths 64 located on the right side thereof.

The transfer electrodes V4 and the transfer electrodes V8 cover the electric charge readout portions 65 corresponding to the photoelectric conversion elements 61R, 61B. Therefore, when the readout pulses are applied to the transfer electrodes V4 and the transfer electrodes V8, the electric charges accumulated in the photoelectric conversion elements 61R, 61B are read out into the vertical electric charge transfer paths 64 located on the right side thereof.

Next, the photographing operation of the digital camera which is configured as shown in Fig. 1 and is mounted with the solid-state imaging device 5" will be described.

During a period in which a mechanical shutter (not shown) mounted on the digital camera is opened, when the imaging device driving section 10 stops a supply of the electronic shutter pulse (SUB pulse) so that the electronic shutter is opened, an exposure period for the photoelectric conversion elements 61 R, 61G, 61 B is started. At this point of time at which the exposure period is started, the transfer pulses of VL are supplied from the imaging device driving section 10 to the respective transfer electrodes V1 to V8.

Immediately before the timing of starting exposure of the photoelectric conversion element 61r, 61g, 61b, the imaging device driving section 10 sets the transfer pulses applied to the transfer electrode V1, V3, V5, V7 to VM. At the timing of starting of exposure of the photoelectric conversion element 61r, 61g, 61b, the imaging device driving section 10 applies the readout pulses of VH to the transfer electrodes V1, V3, V5, V7 so as to read out the electric charges accumulated in the photoelectric conversion elements 61r, 61g, 61b into the vertical electric charge transfer paths 64 through the electric charge readout portions 65. Then, the imaging device driving section 10 executes a driving operation for starting the exposure period for the photoelectric conversion element 61r, 61g, 61b.

After the completion of the application of the readout pulses, the imaging device driving section 10 returns the transfer pulses φV1, φV3, φV5, φV7 to VM. When the mechanical shutter is closed and when the exposure period for the photoelectric conversion element ends, the imaging device driving section 10 controls transfer pulses so as to sweep out unnecessary electric charges existing in the vertical electric charge transfer paths 64 at a high speed. After the completion of the sweeping out of the electric charges, the imaging device driving section 10 applies the readout pulses to the transfer electrodes V2, V4, V6, V8 so as to read out the electric charges accumulated in the photoelectric conversion elements 61R, 61G, 61B into the vertical electric charge transfer paths 64. Then, the imaging device driving section 10 controls the transfer pulses so as to transfer the readout electric charges to the horizontal electric charge transfer path 67 and then further transfer. the electric charges to the output amplifier 68 by the horizontal electric charge transfer path 67. Thereby, signals corresponding to the electric charges accumulated in the photoelectric conversion elements 61 R, 61G, 61 B are output from the solid-state imaging device 5".

Next, the imaging device driving section 10 controls transfer pulses so as to sweep out unnecessary electric charges existing in the vertical electric charge transfer path 64 at a high speed. After the completion of the sweeping out of the electric charges, the imaging device driving section 10 applies the readout pulses to the transfer electrodes V1, V3, V5, V7 so as to read out the electric charges accumulated in the photoelectric conversion elements 61r, 61g, 61b into the vertical electric charge transfer paths 64. Then, the imaging device driving section 10 controls the transfer pulses to transfer the readout electric charges to the horizontal electric charge transfer path 67 and then further transfer the electric charges to the output amplifier 68 by the horizontal electric charge transfer path 67. Thereby, signals corresponding to the electric charges accumulated in the photoelectric conversion elements 61r, 61g, 61b are output from the solid-state imaging device 5".

The digital signal processing section 17 generates image data based on the signals obtained from the photoelectric conversion elements 61R, 61G, 61B and also generates image data based on the signals obtained from the photoelectric conversion elements 61r, 61g, 61b. The digital signal processing section 17 combines these two image data to generate combined image data in which the dynamic range is extended, and outputs the combined image data to the compression/expansion processing section 18. The compression/expansion processing section 18 executes the compression process for the combined image data. The compressed combined image data is recorded in the recording medium 21, and the photographing operation is finished.

As described above, even if the solid-state imaging device is configured as shown in Fig. 7, the driving operation can be executed in the same manner as that of the first embodiment, and the same effect can be achieved. In this connection, even in this embodiment, as described in the second embodiment, if the exposure time for the photoelectric conversion elements 61r, 61 g, 61b is longer than the threshold value, the electric charges may be swept out after the completion of the application of the readout pulses, and then the transfer pulses of VL may be applied to the respective transfer electrodes V1 to V8 until the mechanical shutter is closed.

## Claims

1. An imaging apparatus comprising:
a solid-state imaging device; and
a driving unit configured to drive the solid-state imaging device, wherein the solid-state imaging device includes
a large number of photoelectric conversion elements that are arranged two-dimensionally in a specific direction on a semiconductor substrate and in a direction perpendicular to the specific direction,
electric charge transfer paths that are disposed to correspond to photoelectric conversion element columns each having the plurality of photoelectric conversion elements being arranged in the specific direction, each electric charge transfer path that transfers in the specific direction electric charges generated by the plurality of photoelectric conversion elements of the corresponding photoelectric conversion element column, and
transfer electrodes that are disposed above the electric charge transfer paths and are arranged in the specific direction,
the transfer electrodes includes
first transfer electrodes that are disposed to correspond to the plurality of photoelectric conversion elements of each photoelectric conversion element column, respectively and control (i) reading out of the electric charges from the respective photoelectric conversion elements of each photoelectric conversion element column to the corresponding electric charge transfer path and (ii) transferring of the electric charges in the corresponding electric charge transfer path, and
second transfer electrodes that control the transferring of the electric charges in the electric charge transfer paths,
the large number of photoelectric conversion elements include first photoelectric conversion elements and second photoelectric conversion elements,
an exposure time for the second photoelectric conversion elements is controlled to be shorter than that for the first photoelectric conversion elements,
to the first photoelectric conversion elements, any of (i) a first transfer pulse for forming packets to accumulate electric charges in the electric charge transfer paths, (ii) a second transfer pulse, having a level lower than that of the first transfer pulse, for forming barriers for the packets in the electric charge transfer paths, and (iii) a readout pulse, having a level higher than that of the first transfer pulse, for reading out the electric charges from the photoelectric conversion elements to the electric charge transfer paths can be applied,
any of the first transfer pulse and the second transfer pulse can be applied to the second transfer electrodes,
the driving unit applies the readout pulse to the first transfer electrodes corresponding to the second photoelectric conversion elements during the exposure period for the first photoelectric conversion elements, and upon stop of the reading pulse, the driving unit starts exposing the second photoelectric conversion elements, and
the driving unit applies the second transfer pulse to all the transfer electrodes during a period from start of exposure of the first photoelectric conversion elements to the applying of the readout pulse.

2. The imaging apparatus according to claim 1, wherein the driving unit applies the first transfer pulse to a part of the transfer electrodes including the first and second transfer electrodes during a period from the applying of the readout pulse to an end of the exposure time for the second photoelectric conversion elements.

3. The imaging apparatus according to claim 2, wherein
the part of the transfer electrodes is at least a part of the transfer electrodes except for the transfer electrodes adjacent to the first photoelectric conversion elements or at least a part of the transfer electrodes except for the first transfer electrodes corresponding to the first photoelectric conversion elements, and
during the period from the applying of the readout pulse to the end of the exposure time for the second photoelectric conversion elements, the driving unit applies the second transfer pulse to at least the transfer electrodes adjacent to the first photoelectric conversion elements or the first transfer electrodes corresponding to the first photoelectric conversion elements.

4. The imaging apparatus according to any one of claims 1 to 3, wherein
if the set exposure time for the second photoelectric conversion element is longer than a threshold value, after applying the readout pulse, the driving unit applies the first and second transfer pulses to the transfer electrodes to sweep out electric charges existing in the electric charge transfer paths, and
after the sweeping out is completed, the driving unit applies the second transfer pulse to all the transfer electrodes until the end of the exposure period for the second photoelectric conversion elements.

5. A method for driving a solid-state imaging device, wherein
the solid-state imaging device includes
a large number of photoelectric conversion elements that are arranged two-dimensionally in a specific direction on a semiconductor substrate and in a direction perpendicular to the specific direction,
electric charge transfer paths that are disposed to correspond to photoelectric conversion element columns each having the plurality of photoelectric conversion elements being arranged in the specific direction, each electric charge transfer path that transfers in the specific direction electric charges generated by the plurality of photoelectric conversion elements of the corresponding photoelectric conversion element column, and
transfer electrodes that are disposed above the electric charge transfer paths and are arranged in the specific direction,
the transfer electrodes includes
first transfer electrodes that are disposed to correspond to the plurality of photoelectric conversion elements of each photoelectric conversion element column, respectively and control (i) reading out of the electric charges from the respective photoelectric conversion elements of each photoelectric conversion element column to the corresponding electric charge transfer path and (ii) transferring of the electric charges in the corresponding electric charge transfer path, and
second transfer electrodes that control the transferring of the electric charges in the electric charge transfer paths,
the large number of photoelectric conversion elements include first photoelectric conversion elements and second photoelectric conversion elements,
an exposure time for the second photoelectric conversion elements is controlled to be shorter than that for the first photoelectric conversion elements,
to the first photoelectric conversion elements, any of (i) a first transfer pulse for forming packets to accumulate electric charges in the electric charge transfer paths, (ii) a second transfer pulse, having a level lower than that of the first transfer pulse, for forming barriers for the packets in the electric charge transfer paths, and (iii) a readout pulse, having a level higher than that of the first transfer pulse, for reading out the electric charges from the photoelectric conversion elements to the electric charge transfer paths can be applied, and
any of the first transfer pulse and the second transfer pulse can be applied to the second transfer electrodes,
the method comprising:
applying the readout pulse to the first transfer electrodes corresponding to the second photoelectric conversion elements during the exposure period for the first photoelectric conversion elements;
upon stop of the reading pulse, starting exposing the second photoelectric conversion elements; and
applying the second transfer pulse to all the transfer electrodes during a period from start of exposure of the first photoelectric conversion elements to the applying of the readout pulse.

6. The method according to claim 5, further comprising:
applying the first transfer pulse to a part of the transfer electrodes including the first and second transfer electrodes during a period from the applying of the readout pulse to an end of the exposure time for the second photoelectric conversion elements.

7. The method according to claim 6, wherein the part of the transfer electrodes is at least a part of the transfer electrodes except for the transfer electrodes adjacent to the first photoelectric conversion elements or at least a part of the transfer electrodes except for the first transfer electrodes corresponding to the first photoelectric conversion elements,
the method further comprising:
during the period from the applying of the readout pulse to the end of the exposure time for the second photoelectric conversion elements, applying the second transfer pulse to at least the transfer electrodes adjacent to the first photoelectric conversion elements or the first transfer electrodes corresponding to the first photoelectric conversion elements.

8. The method according to any one of claims 5 to 7, further comprising:
if the set exposure time for the second photoelectric conversion element is longer than a threshold value, after applying the readout pulse, applying the first and second transfer pulses to the transfer electrodes to sweep out electric charges existing in the electric charge transfer paths; and
after the sweeping out is completed, applying the second transfer pulse to all the transfer electrodes until the end of the exposure period for the second photoelectric conversion elements.
